# EUROPÄISCHE PATENTSCHRIFT

(11) **EP 0 513 611 B1**
(45) Veröffentlichungstag und Bekanntmachung des Hinweises auf die Patenterteilung: **07.01.1998**
(21) Anmeldenummer: 92107504.0
(22) Anmeldetag: 04.05.1992
(51) Int. Cl.: G11C 7/00

(54) **Verfahren zur Datenübertragung für einen Halbleiterspeicher und Halbleiterspeicher zur Durchführung des Verfahrens**
Data transfer method for a semiconductor memory and semiconductor memory to perform such a method
Méthode de transfert de données pour une mémoire à semi-conducteurs et mémoire à semi-conducteur pour application de la méthode

(30) Priorität: 06.05.1991 DE 4114744
(43) Veröffentlichungstag der Anmeldung: 19.11.1992
(73) Patentinhaber: SIEMENS AKTIENGESELLSCHAFT, 80333 München (DE)
(72) Erfinder: Sommer, Diether, Dipl.-Phys., D-80469 München 5 (DE); Savignac, Dominique, Dr.rer.nat., W-85737 Ismaning (DE)

(56) Entgegenhaltungen:
- EP-A- 0 174 845
- EDN ELECTRICAL DESIGN NEWS, Bd.36, Nr.11, Mai 1991, NEWTON, MASSACHUSETTS US Seiten 106 - 116 QUINNELL 'HIGH SPEED DRAMS'
- WESCON CONVENTION RECORD, Bd.34, November 1990, NORTH HOLLYWOOD US Seiten 33 - 36 SUSSMAN 'DRAM AND SPECIALTY MEMORIES FOR NEXT GENERATION SYSTEMS'

## Beschreibung

Die Erfindung betrifft ein Verfahren zur Datenübertragung zwischen einer Mehrzahl von Speicherzellen und mindestens einem Eingangs-/Ausgangsanschluß eines Halbleiterspeichers, bei dem eine Speicherzellenadresse mit einem Steuersignal für eine Datenübertragung festgelegt wird, und einen Halbleiterspeicher zur Durchführung des Verfahrens.

Zunehmende Speicherdichten integrierter Halbleiterspeicher und zunehmende Datenwortbreiten erfordern eine Datenübertragung von und zu den Speicherzellen mit möglichst hoher Geschwindigkeit. Übliche Halbleiterspeicher sind in Matrixanordnungen organisiert. Jede einzelne Speicherzelle ist dabei über Wortleitungen und Bitleitungen festgelegt. Ein Zugriff auf eine derartige Speicherzelle erfolgt durch Anlegen einer Adresse, die der Speicherzelle zugeordnet ist, an den Halbleiterspeicher sowie Zeilenadreßsteuersignale (Row Address Strobe, RAS) und Spaltenadreßsteuersignale (Column Address Strobe, CAS). Üblicherweise wird dabei die Zeilen- oder Wortadresse der Speicherzelle adressiert und mit dem Signal RAS selektiert. Danach wird mit dem Signal CAS die Spaltenadresse gültiggeschrieben und somit die Speicherzelle festgelegt.

Aus dem Stand der Technik sind verschiedene funktionale Moden für einen Speicherzellenzugriff bekannt, beispielsweise der sogenannte Pagemodus oder der Nibble-Modus. Im Pagemodus werden üblicherweise die Zeilen mit Speicherzellen entlang einer Wortleitung selektiert, und danach ist mit einer der beiden Taktflanken des Spaltenadreßsteuersignals CAS ein Neuzugriff auf wahlweise Spaltenadressen möglich. Da bei dieser Betriebsart nurmehr die Spaltenadressen für einen einzelnen Zellenzugriff geändert werden müssen, ergibt sich ein Geschwindigkeitsvorteil gegenüber einem Modus, bei dem Spaltenadressen und Zeilenadressen wahlfrei neu festgelegt werden.

Gegenüber dem Pagemodus bedeutet der Nibble-Modus eine deutliche Erhöhung der Datenübertragungsrate. Beim Nibble-Modus gemäß der US-PS 4,344,156 erfolgt mit einer Adressenfestlegung ein Zugriff auf vier Speicherzellen. Diese vier Speicherzellen ergeben sich als mögliche Kombination zweier Adreßindizes der festgelegten Adresse. Die mit einer festgelegten Adresse angesprochenen vier Speicherzellen geben ihre gespeicherten Daten in Zwischenspeicher aus, von denen die Daten an den oder die Eingangs-/Ausgangsanschlüsse des Halbleiterspeichers nach außen geführt werden.

Üblicherweise legt eine fallende CAS-Signalflanke die Spaltenadresse für den Nibble-Takt, d.h. für das Auslesen oder Einlesen von vier Bits in vier Speicherzellen, fest, während mit einer RAS-Flanke ein Neuzugriff auf Speicherzellen erfolgt. Wie beim Pagemodus wird üblicherweise mit der steigenden CAS-Flanke die entsprechende erste Spaltenadresse übernommen und mit der fallenden CAS-Flanke die Daten von dieser Spaltenadresse bzw. Speicherzelle. Beim Nibble-Modus ist für die darauffolgenden drei Speicherzellenzugriffe kein neuer Adreßwechsel erforderlich, so daß im wesentlichen deren Festlegungszeit eingespart wird.

Eine weitere Möglichkeit zur Erhöhung der Datenrate ist aus der Veröffentlichung von K. Numata et al.: New Nibbled-Page Architecture for High-Density DRAMs, IEEE Journal of Solid-State-Circuits, Vol. 24, No. 4, August 1989, S. 900-904 bekannt. Bei dieser sogenannten Nibbled-Page-Architektur kann entlang der selektierten Wortleitung bzw. Speicherzeile auf Spaltenadressen in Einheiten von acht Bits zugegriffen werden. Der Zugriff auf die acht Bits jeder Einheit erfolgt mit der Festlegung einer Adresse. Nach der Festlegung der ersten Adresse und der Datenausgabe der gespeicherten Zellinformation werden mit jeder nächsten der kurz hintereinanderfolgenden negativen Flanken des CAS-Signals die Daten der der ersten Adresse zugeordneten Speicherzellen ausgelesen. Entsprechendes gilt für einen Schreibzyklus. Die Steuerung der Datenausgabe bzw. Dateneingabe erfolgt mit Hilfe des CAS- und des Write Enable (WE) -Signals (Schreibfreigabesteuersignal). Intern sind die den acht Bits zugeordneten Speicherzellen in zwei Zellenbereiche aufgeteilt, denen jeweils vier Bit breite Datenregister zugeordnet sind. Insoweit handelt es sich um einen doppelten Nibble-Modus der bekannten Art. Der Nachteil dieses schnellen Zugriffs liegt darin, daß ein derartig konzipierter Speicherbaustein nur für diesen Zykluszugriff zu gebrauchen ist und daß andere Betriebsmoden nicht oder nur umständlich zu implementieren sind.

Aus der US-PS 4,758,995 ist ein Verfahren zur Datenübertragung bekannt, mit dem ebenfalls mit einer Adreßfestlegung acht Bits hintereinander auslesbar sind. Aus zwei Speicherzellenbereichen werden nach der Adreßübernahme und dem ersten Auslesen der zugeordneten Speicherzelle sieben weitere Bits hintereinander ausgelesen. Ein Zähler steuert die Datenausgabe so, daß rechtzeitig vor Beendigung des Auslesens der ersten vier Speicherzellen die nächsten vier Speicherzellen adressiert und ausgelesen werden können. Entsprechendes gilt für das Schreiben. Auch dieses Verfahren ist als schneller Nibble-Zyklus anzusehen, der für einen Baustein nur dieses Typs zu gebrauchen ist.

Der Erfindung liegt die Aufgabe zugrunde, ein neues Zugriffsverfahren für einen Halbleiterspeicher und einen Halbleiterspeicher zur Durchführung eines derartigen Verfahrens anzugeben. Der Erfindung liegt weiterhin die Aufgabe zugrunde, ein Verfahren zur Datenübertragung für einen Halbleiterspeicher anzugeben, mit dem ein schneller Zugriff auf Speicherzellen möglich ist, ohne daß der Halbleiterspeicher wesentlichen Einschränkungen hinsichtlich der Grundfunktionen unterworfen ist, sowie einen Halbleiterspeicher zur Durchführung dieses Verfahrens vorzusehen.

Die Aufgabe wird gelöst gemäß den Merkmalen des Patentanspruchs 1 bzw. gemäß den Merkmalen des Patentanspruchs 6.

Die Erfindung hat den Vorteil, daß sie eine hohe Datenübertragungsrate von und zu den Speicherzellen ermöglicht, ohne daß die standardisierten Grundfunktionen für Halbleiterspeicher in alternativen Betriebsmoden wesentlich beeinträchtigt werden. Dabei wird zur Steuerung der Datenübertragung das Adreßsteuersignal CAS und ein Ausgangsfreigabe-Steuersignal OE zur Steuerung der Datenübertragung eingesetzt. Das Ausgangsfreigabe-steuersignal (output enable) ist über einen externen Anschlußstift an den Halbleiterspeicher anlegbar, der in Halbleiterspeichern mit mehr als 4MBit Speicherkapazität sowie bei einer x4-Organisation standardmäßig vorhanden ist. Gemäß international gültigen Spezifikationen wird der Datenausgang bzw. Dateneingang in einen tristate-Zustand geschaltet, solange keine zu übertragenden Daten anliegen.

Ausgestaltungen der Erfindung sind in Unteransprüchen gekennzeichnet. Die Erfindung wird nachfolgend anhand eines in den Figuren der Zeichnung dargestellten Ausführungsbeispiels näher erläutert. Dabei betreffen gleiche Bezugszeichen gleiche Elemente. Es zeigen:
- Figur 1: ein Blockschaltbild zur Erläuterung der Erfindung,
- Figur 2: ein Prinzipschaltbild zur Erzeugung interner Steuersignale aus dem Ausgangsfreigabesteuersignal,
- Figur 3: ein Prinzipschaltbild zur Erzeugung interner Adreßsteuersignale,
- Figur 4: ein Prinzipschaltbild zur Erläuterung eines Nibble-Page-Modus,
- Figur 5: ein Prinzipschaltbild zur Erzeugung eines internen Signals für die Ausgabesteuerung,
- Figur 6: ein Prinzipschaltbild zur Erzeugung interner Schreibsteuersignale,
- Figur 7: ein Prinzipschaltbild zur Erzeugung von Adreßsteuersignalen,
- Figur 8: ein Prinzipschaltbild eines Ausgangssteuerkreises,
- Figur 9a: ein Prinzipschaltbild eines Latch-Schaltkreises des Ausgangssteuerkreises,
- Figur 9b: ein Prinzipschaltbild eines Buffer-Schaltkreises,
- Figur 10: ein Prinzipschaltbild zur Erläuterung des Nibble-Modus mit den erfindungsgemäßen Signalen,
- Figur 11: ein Signaldiagramm zur Erläuterung des Nibble-Page-Modus,
- Figur 12: ein Signaldiagramm zur Erläuterung des erfindungsgemäßen Verfahrens bei einem Lesezyklus,
- Figur 13: ein Signaldiagramm zur Erläuterung eines Nibble-Page-Modus bei einem Lesezyklus und
- Figur 14: ein Signaldiagramm zur Erläuterung eines Nibble-Page-Modus bei einem Schreibzyklus.

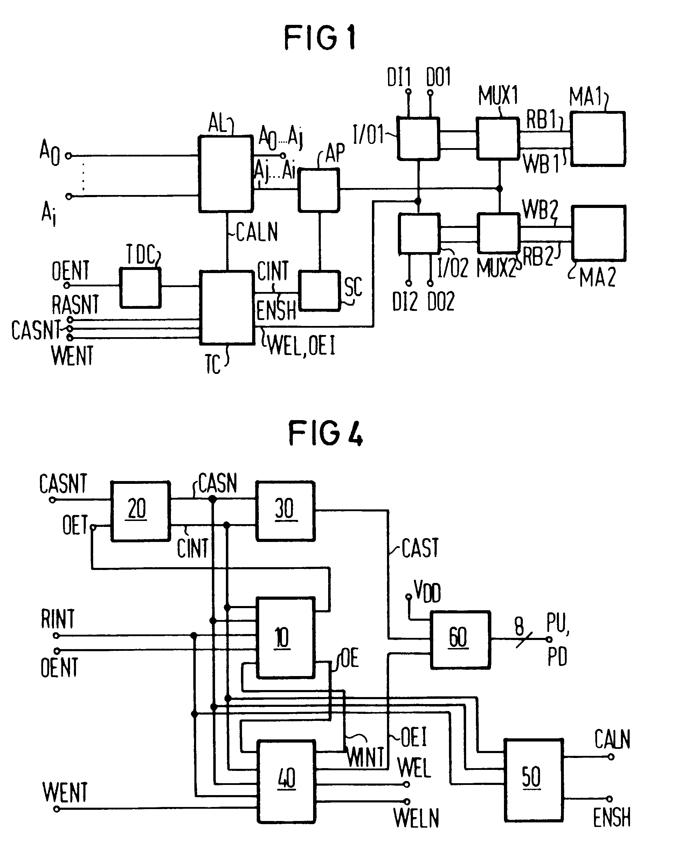

Zur Erläuterung des erfindungsgemäßen Verfahrens zeigt Figur 1 als ein Ausführungsbeispiel ein Blockschaltbild einer Anordnung, das über einen Nibble-Page-Modus verfügt. Die gemäß der Aufgabe gestellte Bedingung, daß die Speicher-Grundfunktionen durch das erfindungsgemäße Verfahren und die entsprechende Anordnung möglichst wenig beeinträchtigt werden, wird dadurch gewährleistet, daß ein Standardzyklus nicht verändert wird, d.h. mit einem RAS- bzw. CAS-Signal erfolgt ein Zugriff auf eine entsprechend ihrer Adresse festgelegte Speicherzelle.

Sofern in der Anmeldung von RAS- und CAS-Signalen die Rede ist, so sind damit Signale in der Form gemeint, wie sie von außen an Anschlußpins des Speichers angelegt werden. Das bedeutet, daß üblicherweise TTL-Signale RAS, CAS, WE und OE in ihrer negierten Form an die Pins angelegt werden. Dies wird durch die Zeichnung RASNT, CASNT, WENT sowie OENT festgelegt. Gemäß Figur 1 bilden diese vier Signale Eingangssteuersignale für den Halbleiterspeicher. Mit RAST und CASNT wird die Adresse einer Speicherzelle festgelegt, mit WENT wird festgelegt, ob der Speicher gelesen oder beschrieben werden soll und OENT gibt üblicherweise einen Ausgangsbuffer für die Datenausgabe frei. In bekannten Speichern wird die Dateneingabe nicht mit einem separaten Steuersignal festgelegt.

Der Grundgedanke der Erfindung beruht darauf, daß wie bei bekannten Speichern mit einem RAS- bzw. CAS-Signal eine Speicherzelle adressiert wird und die Adresse mit einer fallenden CAS-Signalflanke übernommen wird. Eine schnelle Aufeinanderfolge derartiger Haupttakte ist wie bereits dargestellt, vor allem deswegen nicht möglich, weil die Adreßübernahme vergleichsweise viel Zeit kostet. Die Erfindung sieht nun vor, daß zwischen zwei durch RAS und CAS festgelegten Haupttakten zusätzliche Daten ausgelesen werden können, wozu mit Hilfe von CASNT und OENT Steuersignale erzeugt werden. Im Fall eines Nibble-Page-Modus entspricht der Haupttakt dem dem Page-Modus, der mit drei zusätzlichen Datentakten nach jedem Haupttakt einen Nibble-Modus bildet. Auf diese Weise lassen sich die bekannten DRAM-Betriebsmoden Nibble-Modus und Page- bzw. Fast-Page-Modus miteinander kombinieren. Darüber hinaus sind weitere Kombinationen möglich, z.B. write per bit. Die entsprechenden Standardfunktionen werden dabei grundsätzlich nicht beeinträchtigt.

Da die Datenübertragung mit an den äußeren Pins anliegenden Signalen CASNT und OENT gesteuert werden soll, gibt es für diese Steuerung zwei prinzipielle Möglichkeiten. Zum einen kann die eigentliche Datenübertragung mit CASNT gesteuert werden, zum anderen mit OENT. Bei einer Steuerung der Datenübertragung mit CASNT ergibt sich trotz der schnellen Datenübertragung der Nachteil, daß die Übernahme einer neuen Spaltenadresse entsprechend dem CAS-Signal nur zu bestimmten Nibble-Takten möglich ist. Darüber hinaus muß, da der Datenausgangsbus nicht über das CAS-Signal in einen tristate-Zustand geschaltet werden kann, dieser Tristate-Zustand mit OENT festlegbar sein. Sofern die Forderung nach Kompatibilität mit den bekannten Betriebsmoden fallengelassen wird, kann der Datenausgangsbus auch ohne den tristate-Übergang betrieben werden.

Bei einer Steuerung der Datenübertragung mit OENT ergibt sich zwar der Nachteil, daß auch bei einer Speicherausführung in einer x1-Organisation und einer Speicherkapazität ≤ 4MBit ein Anschlußpin für dieses Ausgangsfreigabesteuersignal vorgesehen sein muß. Es ergibt sich jedoch der Vorteil, daß bei einer schnellen Datenübertragung die Übernahme einer neuen Spaltenadresse zu jeder Zeit möglich ist, da das CAS-Signal auf übliche Weise zur Festlegung einer Speicherzelle dient. Mit CASNT kann dann eine laufende Nibble-Sequenz abgebrochen werden und eine Adresse für den neuen Nibble-Zyklus übernommen werden.

Dieser zweite Fall, daß das Adreßsteuersignal CASNT die Speicherzellenadresse festlegt und das Ausgangsfreigabesignal OENT die Datenübertragung steuert, sei anhand Figur 1 erläutert. Dabei wird der Fall betrachtet, daß gemäß einer Ausgestaltung der Erfindung zur weiteren Erhöhung der Datenübertragungsrate nicht nur eine der beiden Signalflanken von OENT, sondern jede der beiden Signalflanken von OENT ein Datum ein- bzw. ausliest. Das erste Datum jeder Nibble-Sequenz wird in die betreffende Speicherzelle geschrieben bzw. ausgelesen, wenn nach der Übernahme einer Adresse mit der negativen Flanke von CASNT die Adresse festgelegt und eine Dateneingabe oder Datenausgabe eingeleitet wird. Das bedeutet, daß ein Datenauslese- bzw. Datenschreibvorgang beginnen kann, wenn konjunktiv CASNT und OENT log. O sind. Für die Datenübertragung, d.h. das Lesen bzw. Einschreiben von Daten ist dann eine Steuerung durch das OENT-Signal vorgesehen, während das CASNT-Signal solange auf log. O bleibt, bis eine neue Adresse übernommen werden soll.

Für die Ablaufsteuerung des erfindungsgemäßen Verfahrens ist in Figur 1 eine Zeitsteueranordnung TC vorgesehen, der die Signale RASNT, CASNT und WENT direkt als Eingangssignale zugeführt werden. Das gemäß der Erfindung mitentscheidende Freigabesteuersignal OENT steht über einen Schaltkreis zur Erkennung eines Datenübergangs TDC in Verbindung mit dem Zeitsteuerschaltkreis TC. Der Schaltkreis TC ist mit einem Adreßpufferschaltkreis AL (address latch) verbunden, an dem die Adreßsignale Aₒ bis Aᵢ anliegen. Da der üblicherweise so verstandene Nibble-Modus einen Satz von vier Daten umfaßt, sind die vier zugeordneten Speicherzellen mit Hilfe zweier Adreßindizes festlegbar. Allerdings ist die Erfindung nicht darauf beschränkt, einen Nibble-Modus mit vier Daten zwischen zwei Haupttakten zu übertragen, sondern es können je nach Anforderung auch mehr, beispielsweise acht oder sechzehn Daten in einem abgewandelten Nibble-Modus übertragen werden. In Figur 1 ist angedeutet, daß die Adressen Aⱼ bis Aᵢ einem Adreßzeiger AP zugeführt werden. Die anderen Adressen Aₒ bis Aⱼ werden, was nicht dargestellt ist, den entsprechenden Dekodern, gegebenenfalls unter Zwischenschaltung weiterer, hier nicht interessierender Funktionsgruppen, zugeführt. Der Adreßzeiger AP hat die Aufgabe, den eigentlichen Nibble-Modus zu steuern. Der Adreßzeiger AP und der Zeitsteuerschaltkreis TC stehen über einen Schiebesteuerschaltkreis (shift control) SC miteinander in Verbindung. Hinsichtlich der eigentlichen Speicherzellenanordnung steht der Adreßzeiger AP mit einem Multiplexer MUX1 in Verbindung, der zwischen der eigentlichen Speicherzellenanordnung MA1 und einer Eingabe-/Ausgabeschaltung I/O1 liegt. Eine derartige Speicherzellenanordnung MA1 kann in mehrere Speicherzellenblöcke mit jeweils einzelnen Speicherzellenfeldern aufgeteilt sein. Eine Speicherzellenanordnung MA1 ist über einen Lesebus RB1 und einen Schreibbus WB1 über den Multiplexer MUX1 mit dem Eingabe-/Ausgabeschaltkreis I/O1 verbunden. Dieser letztere Schaltkreis ist mit extern zugänglichen Anschlußstiften DI1 bzw. DO1 verbunden, die selbstverständlich auch mit einer einzigen Klemme für den Dateneingang bzw. den Datenausgang realisiert sein können. Die Speicherzellenanordnung MA, der Multiplexer MUX und der Eingabe-/Ausgabeschaltkreis I/O können, wie gemäß Figur 1 gezeigt ist, auch mehrfach ausgeführt sein, beispielsweise zweifach oder vierfach. In einem derartigen Fall entsprechen sich die jeweiligen Verbindungen bzw. Steuerungen. Gemäß Figur 1 sind beispielsweise die Multiplexer MUX1 und MUX2 mit dem Adreßzeiger AP verbunden. Über eine separate Schreibsteuerung und eine Freigabe des Datenausgangsbusses bzw. Datenausgangsanschlusses sind die Eingabe-/Ausgabeschaltkreise I/O1 und I/O2 mit dem Zeitsteuerschaltkreis TC verbunden.

Die in Figur 1 dargestellten, aber noch nicht erläuterten Signale werden nachfolgend anhand der weiteren Figuren beschrieben. Im übrigen sind Klemmen und an den Klemmen liegende Signale bzw. Leitungen und über die Leitungen übertragene Signale zur Vereinfachung der Darstellung mit jeweils gleichen Bezugszeichen versehen.

Da die Steuerung der Datenübertragung mit den Signalen CASNT und OENT erfolgt, liegt es auf der Hand, daß bei völlig entsprechender Abwandlung der übrigen Schaltung beispielsweise der Schaltkreis TDC auch zwischen den Anschlußpin CASNT und den Zeitsteuerschaltkreis TC geschaltet werden kann, während dann das Signal OENT direkt dem Zeitsteuerschaltkreis zugeführt werden würde. Für den Fachmann ist ohne weiteres erkennbar, daß die Erfindung nicht nur auf das Ausführungsbeispiel beschränkt ist. Er wird anhand seines fachmännischen Könnens in der Lage sein, weitere Ausführungsbeispiele nach der Lehre der Erfindung vorzusehen.

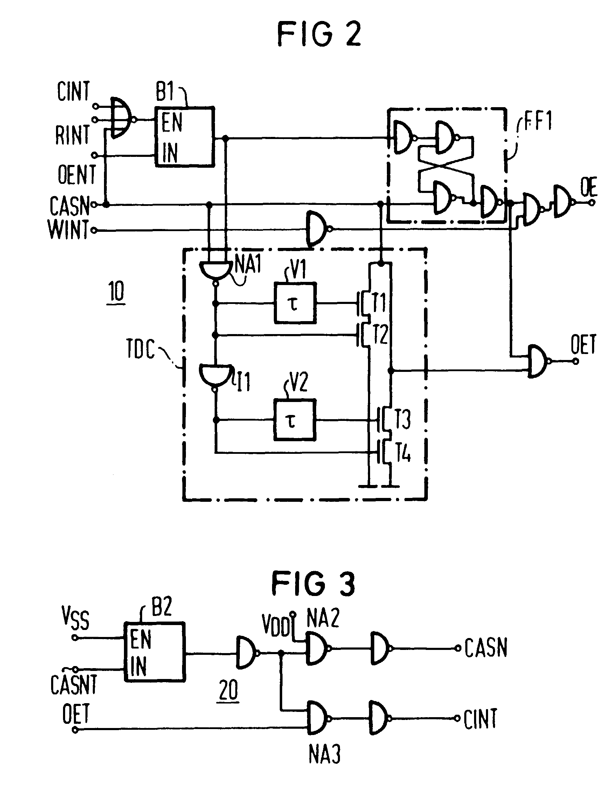

Figur 2 zeigt einen Schaltkreis 10, der den Schaltkreis zur Erkennung eines Signalübergangs TDC beim Signal OENT enthält. Eingangssignal der Schaltung bildet das Signal OENT mit einem TTL-CMOS-Pegel, das an einen äußeren Anschlußpin des Halbleiterspeichers angelegt wird. Dieses Signal wird in einem Buffer B1 auf interne Signalpegel umgesetzt. Freigegeben wird der Buffer B1 mit Hilfe intern erzeugter Steuersignale, die von äußeren Steuersignalen abgeleitet sind. Die Erzeugung dieser internen Steuersignale CINT, RINT und CASN wird noch erläutert. Das Ausgangssignal des Buffers B1 wird mit Hilfe eines Flipflops bis jeweils zum nächsten Signalübergang gespeichert. Am Ausgang des Flipflops FF1 liegt das interne Signal OE.

Der Schaltkreis TDC wird vom Ausgangssignal des Buffers B1, d.h. vom Eingangssignal OENT sowie vom internen Steuersignal CASN gesteuert. Beide Signale werden in einem NAND-Gatter NA1 miteinander verknüpft. Das Ausgangssignal dieses Gatters NA1 wird einmal verzögert und einmal unverzögert zur Ansteuerung zweier Transistoren T1 und T2 verwendet. Das Ausgangssignal des Gatters NA1 wird weiterhin mit Hilfe eines Inverters I1 invertiert, dessen Ausgangssignal in gleicher Weise einmal verzögert und einmal unverzögert zur Ansteuerung zweier Transistoren T3 und 4 verwendet wird. Die beiden Transistorgruppen bilden eine verschaltete ODER-Verknüpfung. Der Ausgang dieser Verknüpfung bildet einen Eingang eines nicht näher bezeichneten weiteren NAND-Gatters, dessen zweiter Eingang vom Signal OE gebildet wird. Ausgangsseitig steht an diesem Gatter das Signal OET zur Verfügung, das zur Ansteuerung eines zu erzeugenden internen Steuersignals CINT vorgesehen ist. Der Vollständigkeit halber sei erwähnt, daß das Flipflop FF1 von dem internen Steuersignal CASN rücksetzbar ist. Das interne Signal WINT dient zum Abschalten des Datenausgangs bzw. des Signals OE.

Figur 3 stellt die Erzeugung des internen Column Address Strobe-Signals CASN aus dem externen TTL-Signal CASNT dar. Das externe Signal wird einem Buffer B2 zugeführt, der das Signal auf interne Spannungspegel umsetzt und am Ausgang einiger weiterer für die Erfindung nicht wesentlicher Logikglieder als internes Signal CASN bereitstellt. Gleichzeitig zeigt Figur 3 die ERzeugung des für die Erfindung wesentlichen internen Steuersignals CINT aus dem Signal OET und dem Steuersignal CASNT. Nach dem Buffer B2 wird das dem Signal CASNT entsprechende Signal mit einem NAND-Gatter NA3 logisch verknüpft, um das interne Steuersignal CINT zu erzeugen. Dieses interne Steuersignal CINT ist ein maßgebliche Signal zur Steuerung der Datenübertragung. Wie anhand der Erzeugung dieses Signals gemäß den Figuren 2 und 3 klar wird, stellt CINT ein Einzelpulssignal dar, bei dem jeweils dann ein Puls erzeugt wird, wenn das Signal CASN einen vorgegebenen logischen Zustand einnimmt und ein Signalwechsel des logischen Zustands von OENT erfolgt.

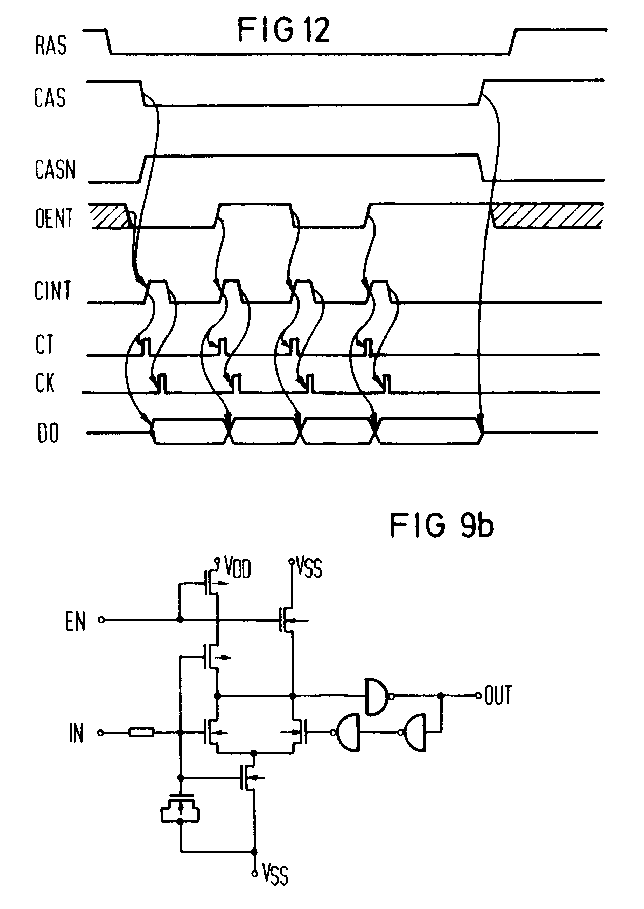

Anhand von Figur 12 sei dieser Zusammenhang erläutert. Wenn mit dem Signal RAS eine Wortleitung selektiert ist und das Signal Column Address Strobe CAS einen Speicherzellenzugriff ermöglicht, wird der erste Puls des Signals CINT erzeugt, sobald neben CAS das Signal OENT log. O ist. Die konjunktive Verknüpfung dieser Logikbedingungen ist deshalb für die erstmalige Erzeugung des CINT-Pulses notwendig. Mit jedem darauffolgenden Signalwechsel des Logikzustands von OENT wird ein weiterer Puls von CINT erzeugt. Jeweils eine der beiden Signalflanken von CINT steuert dann die Datenübertragung. Die Daten liegen dabei solange an, bis mit der maßgeblichen Flanke von CINT das nächste Datum übernommen wird oder aber der Zyklus mit Hilfe des Signals CAS abgebrochen wird.

Anhand der bisher dargestellten Figuren wird der Grundgedanke der Erfindung klar. Da die Datenübertragung für den Halbleiterspeicher, bedingt durch die erforderliche Übernahme und Festlegung der Speicherzellenadressen, mit externen Signalen nicht schnell genug "getogglet" werden kann, werden interne Steuerpulse CINT erzeugt, die von den externen Column Address Strobe-Signalen CAS in Verbindung mit den externen OENT-Signalen gesteuert werden. Auf diese Weise wird eine bisher bereits bekannte Standardfunktion der internen Steuerung übergeordnet. Die interne Steuerung mit Hilfe des Signals CINT ist nicht den zeitlichen Einschränkungen des Signals CAS unterworfen und ermöglicht die schnelle Datenübertragung.

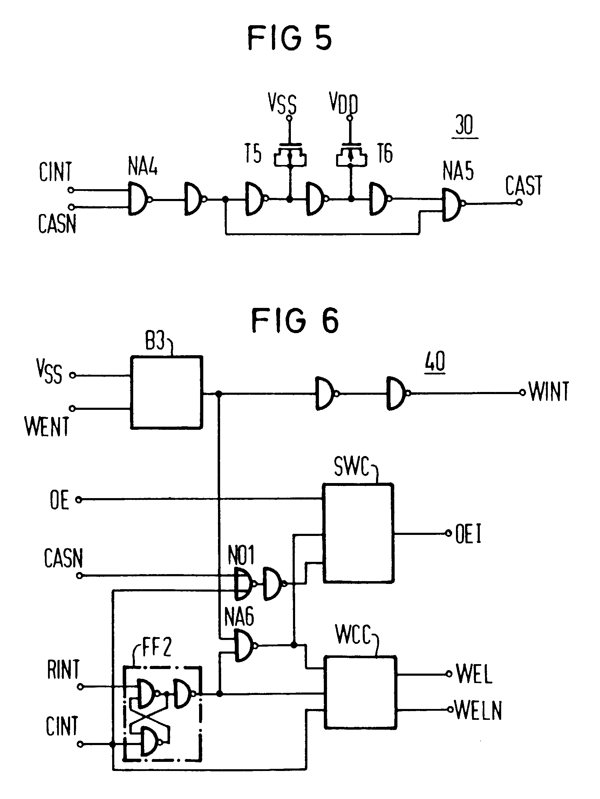

Figur 4 zeigt weitere Einzelheiten für die Realisierung eines Nibble-Page-Modus gemäß Figur 1. Die Schaltkreise 10 und 20 sind anhand von Figur 2 und Figur 3 bereits erläutert worden. Zu erwähnen ist, daß das Signal RINT aus dem Signal RASNT durch Umsetzung der externen Signalpegel auf interne Signalpegel mit Hilfe eines Buffers erzeugt wird. Der Schaltkreis 30 erzeugt aus den internen Signalen CASN und CINT ein Ausgangssignal CAST, das zur Steuerung des Datenbusses dient. Der Schaltkreis 60 verbindet den internen Datenbus mit der Ausgangsstufe. Der Schaltkreis 40 enthält die Schreibsteuerung, die ein internes Signal WINT aus dem externen Signal WENT erzeugt sowie ein Steuersignal OEI für den Bussteuerbaustein 60 und das Schreibsteuersignal Write Enable Latch WEL bzw. dessen invertiertes Signal WELN. Der Schaltkreis 50 erzeugt Steuersignale für den Adreßbuffer AL und den Adreßzeiger AP. Erkennbar sind die internen Signale RINT, CASN und CINT neben dem Signal WINT die maßgeblichen Signale für die Steuerung der gesamten Datenübertragung.

Figur 5 zeigt ein Detailschaltbild des Schaltkreises 30 zur Erzeugung des Signals CAST. Die beiden Steuersignale CINT und CASN werden miteinander im Gatter NA4 logisch verknüpft und dann einmal verzögert und einmal unverzögert einem weiteren Gatter NA5 zugeführt, dessen Ausgangssignal CAST ist. Der Schaltkreis gemäß Figur 5 dient dazu, nur eine Signalflanke von CINT als wirksame Flanke auszuwählen.

Figur 6 zeigt den Schreibsteuerschaltkreis 40. Das externe Schreibsteuersignal WENT wird mit einem Buffer B3 in ein internes Signal WINT umgesetzt. Das Ausgangssignal des Buffers B3 dient zusammen mit den Signalen RINT und CINT zur Steuerung des eigentlichen Schreibsteuerschaltkreises WCC, der die Schreibsteuersignale erzeugt. Die Realisierung dieses Schaltkreises WCC ist dem Fachmann ohne weiteres geläufig. Das Ausgangssignal des Buffers E3 dient ebenfalls zur Steuerung eines Schaltkreises SWC, der das Signal OEI erzeugt, das für die Steuerung des Datenbusses abhängig vom Signal Write Enable verantwortlich ist.

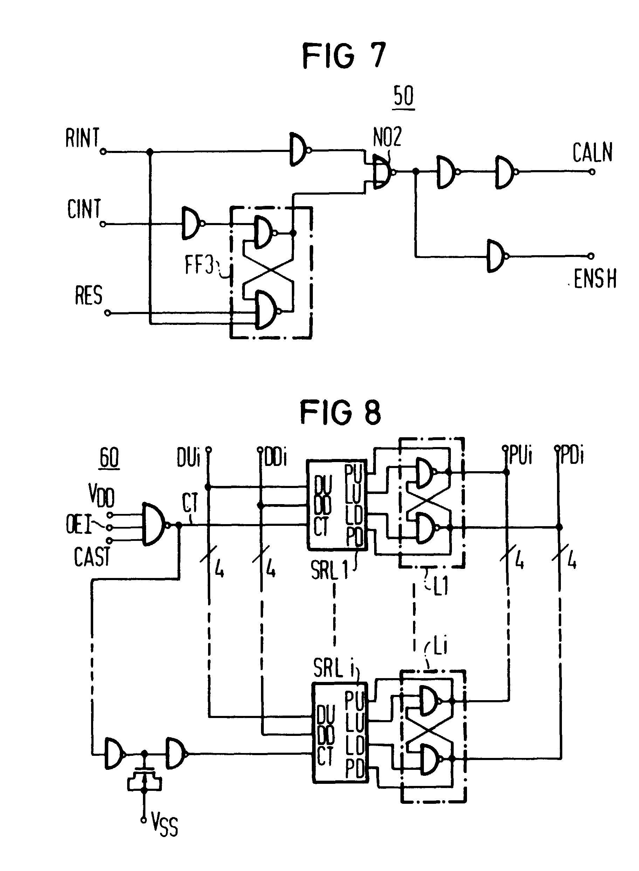

Figur 7 zeigt den Schaltkreis 50, der für die Erzeugung der Adreßsteuersignale CALN und ENSH dient. Die Signale RINT und CINT werden in einem NOR-Gatter NO2 logisch miteinander verknüpft und erzeugen ein Signal CALN, das den Schaltkreis Address Latch AL steuert und ein demgegenüber invertiertes Steuersignal ENSH, das den Schiebesteuerschaltkreis SC (shift control) steuert, der wiederum mit Hilfe des Adreßzeigers AP eine Nibble-Sequenz festlegt. Das Signal RES für das Flipflop FF3 ist ein Reset-Signal, das von internen Steuersignalen abhängt.

Figur 8 zeigt den Schaltkreis 60, der die Steuerung vom internen Datenbus DUi bzw. DDi auf den externen Bus PUi bzw. PDi enthält. Die Busse umfassen im Ausführungsbeispiel jeweils vier Datenleitungen für Data up, Data down, Pull up bzw. Pull down. Der interne Datenbus ist dabei auf logisch High vorgeladen. Das Signal CAST, das entsprechend einer wirksamen Flanke von CINT ausgewählt ist, sowie das Signal OEI werden miteinander logisch zum Signal CT verknüpft. Dieses Signal dient neben dem Datenbus als Eingangssignal für die Set/Reset-Latch-Elemente SRL1 bis SRLi. Die Anzahl dieser Latches entspricht der Anzahl der I/O-Gruppen und damit der Anzahl der Datenleitungsgruppen, d.h. im Ausführungsbeispiel vier. Das Signal OEI hängt dabei davon ab, ob ein Early Write-Zustand vorliegt, bei dem die wirksame Flanke des Signals WENT vor der wirksamen Flanke des Signals CASNT anliegt. In diesem Fall befinden sich die Eingangs-/Ausgangsleitungen in einem Tristate-Zustand, so daß ein Dateneingang/-ausgang nicht zugelassen ist. Im umgekehrten Fall, daß die wirksame Flanke von Write Enable nach der wirksamen Flanke von CASNT auftritt, ist der Dateneingang/-ausgang freigegeben.

Befindet sich das Signal CT auf logisch hohem Potential, dann sind die Eingangssignale für die Ausgangs-Latches L1 bis Li an den Anschlüssen LU und LD auf logisch niedrigem Potential und entsprechend sind die Leitungen des Busses PUi sowie PDi auf logisch hohem Potential, d.h. in einem Tristate-Zustand. Befindet sich das Signal CT auf logisch niedrigem Potential, so kann mit einer Signaländerung des Datenbusses DU bzw. DD eines der Latches LRLi bzw. Li gesetzt werden und somit das Datensignal an den Ausgangsbus übertragen werden. Die nächste wirksame Flanke von CINT ermöglicht dann eine neue Datenübernahme vom internen Datenbus DU und DD in die Latches.

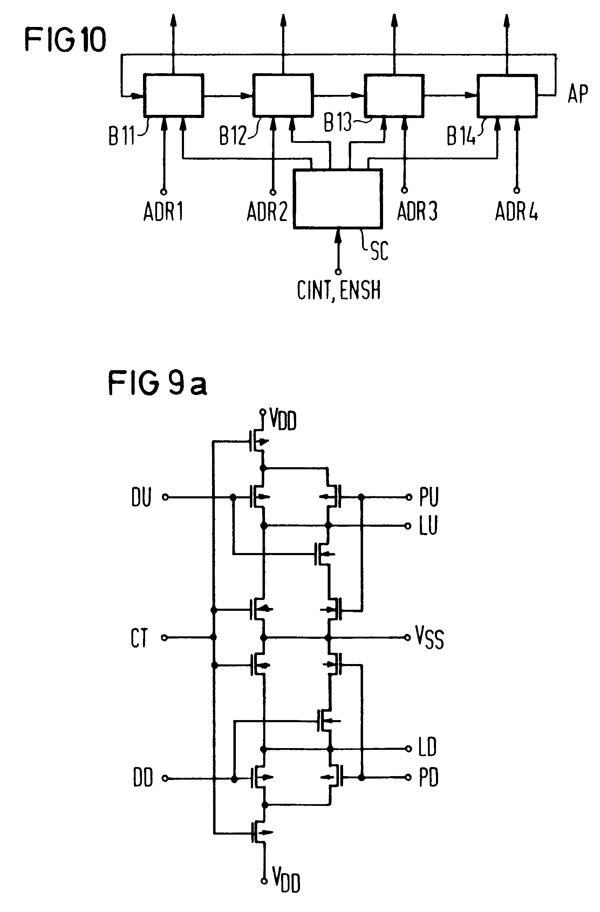

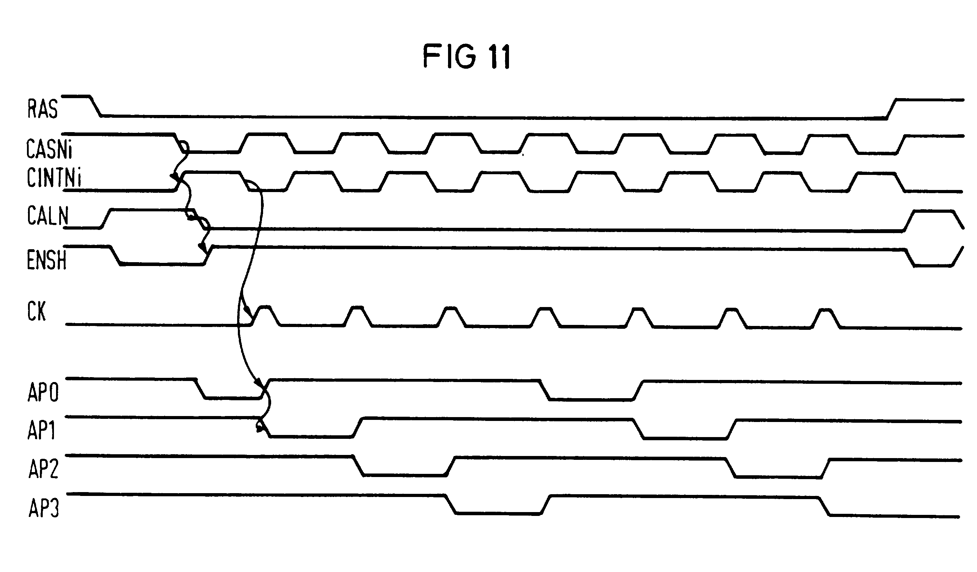

Figur 9a stellt ein detailliertes Schaltbild des Set/Reset-Latch SRLi dar. Figur 9b zeigt ein detailliertes Schaltbild eines Adreßbuffers.

Figur 10 zeigt ein Blockschaltbild zur Erläuterung des Nibble-Modus nach dem Stand der Technik. Die zu einer Nibble-Sequenz gehörenden Adressen ADR1 bis ADR4 liegen an Buffern B11 bis B14 des Adreßzeigers AP an. Diese Buffer sind in einem Ringkreis miteinander verbunden. Die Schiebesteuerschaltung SC wird von den Signalen CINT und ENSH gesteuert und gibt Steuersignale an die Buffer. In einer Nibble-Sequenz werden die vier zugehörigen Speicherzellen entweder gleichzeitig zunächst in einen Zwischenspeicher gelesen und danach entsprechend der Ringsteuerung durch die Buffer direkt nacheinander ausgelesen oder aber die einzelnen Speicherzellen werden direkt nacheinander gelesen und die Daten ausgegeben.

Das Signaldiagramm gemäß Figur 11 erläutert diesen bekannten Nibble-Modus. Mit einer fallenden Signalflanke des Signals CASNi wird im beschriebenen Modus mit Hilfe der Signale CINTNi und ENSH der Adreßzeiger APi gesetzt, und mit der fallenden Signalflanke von CINTNi wird ein Taktsignal CK erzeugt sowie der zuvor gesetzte Adreßzeiger rückgesetzt und der nächste Adreßzeiger gesetzt. In jeder Nibble-Sequenz läuft dieser Vorgang viermal ab. Erfindungsgemäß kann dieser Vorgang beliebig lange zyklisch fortgesetzt werden.

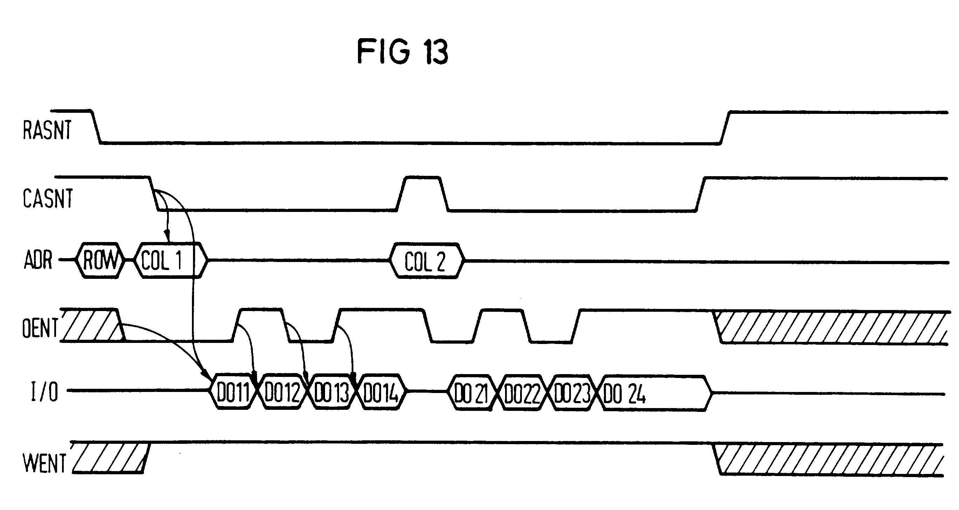

Figur 13 zeigt Signaldiagramme für einen Lesezyklus im Nibble-Page-Modus, der durch Signalübergänge des Output Enable-Signals OE gesteuert wird. Mit der fallenden Signalflanke CAS wird die erste Spaltenadresse übernommen bzw., da OE bereits auf logisch niedrigem Potential ist, wird die entsprechende Speicherzelle festgelegt und gleichzeitig der Eingangs-/Ausgangsschaltkreis freigegeben. Die beiden fallenden Signalflanken CAS und OE leiten den Lesevorgang ein. Beide Flanken werden konjunktiv miteinander verknüpft, wobei der erste Lesevorgang für DO11 in diesem Fall gesteuert wird durch die negative Flanke von CAS. Die drei nachfolgenden Daten werden durch jeweils eine Flanke des Signals OE gesteuert. Nach Ablauf dieser Nibble-Sequenz wird mit der steigenden Flanke von CAS die nächste Spaltenadresse COL2 übernommen und mit der nächsten fallenden Flanke werden die zugehörigen Daten einer Nibble-Sequenz ausgelesen. Das Signal CAS steuert somit den Page-Modus, während der Nibble-Modus in jedem Page-Intervall mit dem Signal OE gesteuert wird.

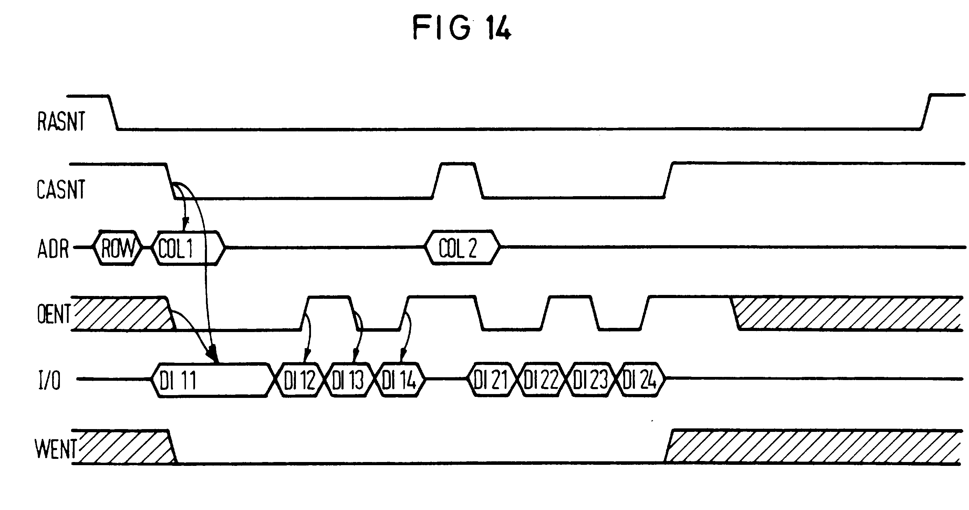

Entsprechendes gilt für den Figur 13 entsprechenden Schreibzyklus gemäß Figur 14.

Anhand der Figuren 13 und 14 wird ohne weiteres klar, daß durch die Steuerung des Page-Modus mit CAS und des Nibble-Modus durch jede Signalflanke durch OE sich die Datenübertragungsrate ohne weiteres verdoppeln läßt. Im Ausführungsbeispiel ist ein einfacher Nibble-Modus gewählt, es sind jedoch auch auf jeder Page 8, 16 oder weitere Nibble Datenübertragungen möglich. Dies entspräche 2, 4 oder weiteren Nibble-Sequenzen.

Der Vorteil des erfindungsgemäßen Verfahrens und des erfindungsgemäßen Speichers besteht darin, daß das Signal CAS entsprechend seiner standardisierten Spezifikation für seine ursprüngliche Bestimmung als Spaltenadreßbewertungssignal (Column Address Strobe) und zum Abbrechen des seriellen Datenstroms benutzt werden kann, indem der Datenausgang in einen Tristate-Zustand gebracht wird. Selbstverständlich kann der beschriebene Modus in eine x4-Organisation problemlos übertragen werden, und eine Kombination mit einer Write-Per-Bit-Funktion ist problemlos möglich. Weitere Ausgestaltungen des Erfindungsgedankens liegen für den Fachmann auf der Hand. So ist selbstverständlich auch ein serieller Page-Modus möglich, der vom Signal OE gesteuert wird. Maßgeblich ist in diesem Fall immer eine der beiden Signalflanken des OE-Signals. an erhält dabei eine vergrößerte Page-Länge mit erhöhter Datenrate, bei der der serielle Datenzyklus mit dem CAS-Signal abgebrochen werden kann. Wie schon im beschriebenen Ausführungsbeispiel steuert CAS die Spaltenadreßübernahme und der Datenausgang wird von OE gesteuert. Andererseits ist auch ein serieller Page-Modus möglich, bei dem die Datenübertragung vom Signal CAS selber gesteuert wird. Der Tristate-Zustand des Datenausgangs wird dabei von OE eingestellt. Bei dieser Ausführungsform ist ein Standard-Page-Modus nicht möglich, da die Datenübertragung von CAS gesteuert wird und somit eine Adreßübernahme nur zu bestimmten Zeitpunkten, d.h. nach einer Anzahl von CAS-Signalwechseln stattfinden kann. Zweckmäßigerweise ist dafür ein Zähler vorgesehen. Möglich ist auch ein Erkennen eines Adreßwechsels mit dem Abbrechen eines Nibble-Zyklus. Schließlich kann ein eigener Takt erzeugt werden, mit dem eine neue Adresse übernommen werden kann.

## Patentansprüche

1. Verfahren zur Datenübertragung zwischen einer Mehrzahl von Speicherzellen und mindestens einem Eingangs-/Ausgangsanschluss eines Halbleiterspeichers, bei dem eine Speicherzellenadresse mit einem ersten Adresssteuersignal für eine Datenübertragung festgelegt wird, **dadurch gekennzeichnet,**
dass ein Datenübertragungsvorgang von bzw. zu den Speicherzellen (MA) von einem zweiten Adresssteuersignal (CASNT) und einem Ausgangsfreigabe-Steuersignal (OENT), derart steuerbar ist, dass eines der beiden Signale eine Speicherzellenadresse festlegt, dass danach der Datenübertragungsvorgang bei einer gegebenen logischen Verknüpfung der beiden Signale eingeleitet wird und dass die anschließende Datenübertragung mit dem anderen der beiden Signale steuerbar ist.

2. Verfahren nach Anspruch 1,
**dadurch gekennzeichnet,**
daß mit jeder festgelegten Speicherzellenadresse ein Datenzugriff auf eine Mehrzahl von Speicherzellen ausführbar ist.

3. Verfahren nach Anspruch 1 oder 2,
**dadurch gekennzeichnet,**
daß das zweite Adreßsteuersignal (CASNT) die Speicherzellenadresse festlegt und das Ausgangsfreigabe-Steuersignal (OENT) die Datenübertragung mit jeweils einer seiner Signalflanken steuert.

4. Verfahren nach Anspruch 1 oder 2,
**dadurch gekennzeichnet,**
daß das zweite Adreßsteuersignal (CASNT) die Speicherzellenadresse festlegt und das Ausgangsfreigabe-Steuersignal (OENT) die Datenübertragung mit jeder seiner Signalflanken steuert.

5. Verfahren nach einem der vorhergehenden Ansprüche,
**dadurch gekennzeichnet,**
daß das zweite Adreßsteuersignal (CASNT) mit einer seiner Taktflanken einen der festgelegten Speicherzellenadresse zugeordneten Datenübertragungsvorgang beendet.

6. Halbleiterspeicher mit einer Mehrzahl von Speicherzellen und mindestens einem Eingangs-/Ausgangsanschluss, mit Mitteln zur Adressierung und mit Mitteln zur Festlegung der Speicherzellen durch ein erstes Adresssteuersignal sowie mit Mitteln zur Steuerung einer Datenübertragung von und zu den Speicherzellen, **dadurch gekennzeichnet**,
dass ein zweites Adresssteuersignal (CASNT) und ein Ausgangsfreigabe-Steuersignal (OENT) vorgesehen sind, die gemeinsam einen Datenübertragungsvorgang steuern, indem eines der beiden Signale zur Festlegung einer Speicherzellenadresse und das andere der beiden Signale zur Steuerung der Datenübertragung dient, nachdem der Datenübertragungsvorgang bei einer gegebenen logischen Verknüpfung der beiden Signale eingeleitet ist.

7. Speicher nach Anspruch 6,
**dadurch gekennzeichnet,**
daß mit jeder festgelegten Speicherzellenadresse die Mittel zur Adressierung der Speicherzellen auf eine Mehrzahl von Speicherzellen zugreifen.

8. Speicher nach Anspruch 6 oder 7,
**dadurch gekennzeichnet,**
daß das zweite Adreßsteuersignal (CASNT) zur Festlegung der Speicherzellenadresse dient und das Ausgangsfreigabe-Steuersignal (OENT) mit jeweils einer seiner Signalflanken die Datenübertragung steuert.

9. Speicher nach Anspruch 6 oder 7,
**dadurch gekennzeichnet,**
daß das zweite Adreßsteuersignal (CASNT) zur Festlegung der Speicherzellenadresse dient und das Ausgangsfreigabe-Steuersignal (OENT) mit jeder seiner Signalflanken die Datenübertragung steuert.

10. Speicher nach einem der vorhergehenden Ansprüche,
**dadurch gekennzeichnet,**
daß der einer festgelegten Speicherzellenadresse zugeordnete Datenübertragungsvorgang mit einer der Taktflanken des zweiten Adreßsteuersignals (CASNT) abbrechbar ist.

## Claims

1. Method for transmitting data between a plurality of memory cells and at least one input/output connection of a semiconductor memory, in which a memory cell address is defined with a first address control signal for a data transmission, characterized in that a data transmission procedure from and/or to the memory cells (MA) can be controlled by a second address control signal (CASNT) and an output enable control signal (OENT) in such a way that one of the two signals defines a memory cell address, that the data transmission procedure is then initiated when there is a given logical connection of the two signals, and that the subsequent data transmission can be controlled with the other of the two signals.

2. Method according to Claim 1, characterized in that a data access to a plurality of memory cells can be executed with each defined memory cell address.

3. Method according to Claim 1 or 2, characterized in that the second address control signal (CASNT) defines the memory cell address, and the output enable control signal (OENT) controls the data transmission with one of its signal edges in each case.

4. Method according to Claim 1 or 2, characterized in that the second address control signal (CASNT) defines the memory cell address, and the output enable control signal (OENT) controls the data transmission with each of its signal edges.

5. Method according to one of the preceding claims, characterized in that the second address control signal (CASNT) terminates, with one of its clock pulse edges, a data transmission procedure assigned to the defined memory cell address.

6. Semiconductor memory having a plurality of memory cells and at least one input/output connection, having means for addressing, and having means for defining, the memory cells by means of a first address control signal, as well as having means for controlling a data transmission from and to the memory cells, characterized in that a second address control signal (CASNT) and an output enable control signal (OENT) are provided, which signals together control a data transmission procedure in that one of the two signals serves to define a memory cell address and the other of the two signals serves to control the data transmission after the data transmission procedure has been initiated when there is a given logical connection of the two signals.

7. Memory according to Claim 6, characterized in that the means for addressing the memory cells access a plurality of memory cells with each defined memory cell address.

8. Memory according to Claim 6 or 7, characterized in that the second address control signal (CASNT) serves to define the memory cell address, and the output enable control signal (OENT) controls the data transmission with one of its signal edges in each case.

9. Memory according to Claim 6 or 7, characterized in that the second address control signal (CASNT) serves to define the memory cell address, and the output enable control signal (OENT) controls the data transmission with each of its signal edges.

10. Memory according to one of the preceding claims, characterized in that the data transmission procedure which is assigned to a defined memory cell address can be aborted with one of the clock pulse edges of the second address control signal (CASNT).

## Revendications

1. Procédé de transfert de donnée entre une pluralité de cellules de mémoire et au moins une borne d'entrée/sortie d'une mémoire à semi-conducteurs, selon lequel on détermine une adresse de cellule de mémoire au moyen d'un premier signal de commande d'adresse pour un transfert de données, caractérisé par le fait que
on peut commander une opération de transfert de données depuis ou vers les cellules de mémoire (MA) au moyen d'un second signal de commande d'adresse (CASNT) et d'un signal de commande d'autorisation de sortie (OENT) de telle sorte qu'un des deux signaux détermine une adresse de cellule de mémoire, que l'on déclenche ensuite l'opération de transfert de données pour une combinaison logique donnée des deux signaux et que l'on peut commander le transfert de données venant ensuite au moyen de l'autre signal.

2. Procédé selon la revendication 1,
caractérisé par le fait que
on peut mettre en oeuvre avec chaque adresse de cellule de mémoire déterminée un accès de données à une pluralité de cellules de mémoire.

3. Procédé selon la revendication 1 ou 2,
caractérisé par le fait que
le second signal de commande d'adresse (CASNT) détermine l'adresse de cellule de mémoire et le signal de commande d'autorisation de sortie (OENT) commande le transfert de données par respectivement un de ses flancs de signal.

4. Procédé selon la revendication 1 ou 2,
caractérisé par le fait que
le second signal de commande d'adresse (CASNT) détermine l'adresse de cellule de mémoire et le signal de commande d'autorisation de sortie (OENT) commande le transfert de données par chacun de ses flancs de signal.

5. Procédé selon l'une des revendications précédentes,
caractérisé par le fait que
le second signal de commande d'adresse (CASNT) termine par un de ses flancs de cadence une opération de transfert de données associée à l'adresse de cellule de mémoire déterminée.

6. Mémoire à semi-conducteurs ayant une pluralité de cellules de mémoire et au moins une borne d'entrée/sortie, des moyens destinés à l'adressage et des moyens destinés à la détermination des cellules de mémoire par un premier signal de commande d'adresse ainsi que des moyens destinés à la commande d'un transfert de données depuis et vers les cellules de mémoire,
caractérisée par le fait que
il est prévu un second signal de commande d'adresse (CASNT) et un signal de commande d'autorisation de sortie (OENT) qui commandent conjointement une opération de transfert de données, de sorte qu'un des deux signaux sert à déterminer une adresse de cellule de mémoire et l'autre signal sert à la commande du transfert de données après que l'opération de transfert de données a été déclenchée lors d'une combinaison logique donnée des deux signaux.

7. Mémoire selon la revendication 6,
caractérisée par le fait que
avec chaque adresse de cellule de mémoire déterminée, les moyens destinés à l'adressage des cellules de mémoire accèdent à une pluralité de cellules de mémoire.

8. Mémoire selon la revendication 6 ou 7,
caractérisée par le fait que
le second signal de commande d'adresse (CASNT) sert à déterminer l'adresse de cellule de mémoire et le signal de commande d'autorisation de sortie (OENT) commande, respectivement par l'un de ses flancs de signal, le transfert de données.

9. Mémoire selon la revendication 6 ou 7,
caractérisée par le fait que
le second signal de commande d'adresse (CASNT) sert à déterminer l'adresse de cellule de mémoire et le signal de commande d'autorisation de sortie (OENT) commande, par chacun de ses flancs de signal, le transfert de données.

10. Mémoire selon l'une des revendications précédentes,
caractérisée par le fait que
l'opération de transfert de données associée à une adresse de cellule de mémoire déterminée peut être interrompue par l'un des flancs de cadence du second signal de commande d'adresse (CASNT).
